# EUROPÄISCHE PATENTANMELDUNG

(11) **EP 2 991 124 A1**
(43) Veröffentlichungstag der Anmeldung: **02.03.2016**
(21) Anmeldenummer: 15000004.0
(22) Anmeldetag: 06.01.2015
(51) Int. Cl.: H01L 31/0687, H01L 31/0304, H01L 31/18

(54) **Stapelförmige integrierte Mehrfachsolarzelle und Verfahren zur Herstellung einer stapelförmigen integrierten Mehrfachsolarzelle**

(30) Priorität: 29.08.2014 EP 14002989
(71) Anmelder: AZUR SPACE Solar Power GmbH, 74072 Heilbronn (DE)
(72) Erfinder: Kubera, Tim, 74072 Heilbronn (DE); Roesener, Tobias, 81369 München (DE)
(74) Vertreter: Koch Müller Patentanwaltsgesellschaft mbH

(57) **Zusammenfassung**

Stapelförmige Integrierte Mehrfachsolarzelle, mit einer oberen Teilzelle und einer unteren Tellzelle, wobei die obere Teilzelle eine größere Bandlücke als die untere Teilzelle aufweist, und jede der Teilzellen einen Emitter und eine Basis aufweist, und die untere Teilzelle eine InGaNAs-Schicht aufweist und die Dicke der InGaNAs-Schicht größer als 100 nm ist und die InGaNAs - Schicht als Tell des Emitters und / oder als Teil der Basis und / oder als Teil der zwischen Emitter und Basis liegenden Raumladungszone ausgebildet ist, und unterhalb der InGaNAs-Schicht eine planare und im Wesentlichen vollflächige oder vollflächige Anschlusskontaktschicht aus Metall ausgebildet ist und die Anschlusskontaktschicht eine stoffschlüssige Verbindung zu einer III-V Halbleiterschicht der darüber liegenden unteren Teilzelle aufweist oder unter-halb der InGaNAs-Schicht eine amorphe Halbleiterverbindungsschicht ausge-bildet ist, wobei die Halbleiterverbindungsschicht eine Dicke dₐ mit 1 nm ≤ dₐ ≤ 50 nm umfasst und die Halbleiterverbindungsschicht für Wellenlängen oberhalb 1240 n nm transparent ist und die Halbleiterverbindungsschicht in dem Wellenlängenbereich oberhalb 1240 nm weniger als 25% der Photonen absorbiert.

## Beschreibung

Stapelförmige integrierte Mehrfachsolarzelle und Verfahren zur Herstellung einer stapelförmigen integrierten Mehrfachsolarzelle.

Die Erfindung betrifft eine stapelförmige integrierte Mehrfachsolarzelle und ein Verfahren zur Herstellung einer stapelförmigen integrierten Mehrfachsolarzelle.

Aus der EP 2 180 524 A2 ist eine Solarzellenanordnung bekannt. Ferner ist aus "Magnifying margins wlth mirocells" aus der Druckschrift, Compound Semiconductor, S. 24 bis S.38, July 2014 eine Dreifachzelle mit einer unteren Zelle aus InGaNAs.

Vor diesem Hintergrund besteht die Aufgabe der Erfindung darin, eine Anordnung und ein Verfahren anzugeben, die jeweils den Stand der Technik weiterbilden.

Die Aufgabe wird durch eine stapelförmige integrierte Mehrfachsolarzelle und Verfahren zur Herstellung einer stapelförmigen integrierten Mehrfachsolarzelle mit den Merkmalen des Patentanspruchs 1 und den Merkmalen des Patentanspruchs 11 gelöst. Vorteilhafte Ausgestaltungen der Erfindung sind Gegenstand von Unteransprüchen.

Gemäß dem ersten Gegenstand der Erfindung wird eine stapelförmige monolithisch integrierte Mehrfachsolarzelle bereitgestellt, mit einer oberen Teilzelle und einer unteren Teilzelle, wobei die obere Teilzelle eine größere Bandlücke als die untere Teilzelle aufweist, und jede der Teilzellen einen Emitter und eine Basis aufweist, und die untere Teilzelle eine InGaNAs-Schicht aufweist und die Dicke der InGaNAs-Schicht größer als 100 nm ist und die InGaNAs - Schicht als Teil des Emitters und / oder als Teil der Basis und / oder als Teil der zwischen Emitter und Basis liegenden Raumladungszone ausgebildet ist, und die untere Teilzelle eine Fläche größer als 1 mm² aufweist, und in einer ersten Alternative unterhalb der InGaNAs-Schicht eine planare und im Wesentlichen vollflächige oder vollflächige Anschlusskontaktschicht aus Metall ausgebildet ist und die Anschlusskontaktschicht eine stoffschlüssige Verbindung zu einer III-V Halbleiterschicht der darüber liegenden unteren Teilzelle aufweist und die Anschlusskontaktschicht weniger als 20 µm von der unteren Teilzelle entfernt ist, oder in einer zweiten Alternative unterhalb der InGaNAs-Schicht eine amorphe Halbleiterverbindungsschicht ausgebildet ist, wobei die Halbleiterverbindungsschicht eine Dicke dₐ mit 1 nm ≤ dₐ ≤ 50 nm umfasst und die Halbleiterverbindungsschicht für Wellenlängen oberhalb 1240 n nm transparent ist und die Halbleiterverbindungsschicht in dem Wellenlängenbereich oberhalb 1240 nm weniger als 25% der Photonen absorbiert.

Gemäß dem zweiten Gegenstand der Erfindung wird ein Verfahren zur Herstellung einer stapelförmigen integrierten Mehrfachsolarzelle bereitgestellt, wobei in einem ersten Schritt eine obere Teilzelle auf einer Halbleitersubstratscheibe mittels eines Epitaxie Prozesses hergestellt wird, und in einem zweiten Schritt eine untere Teilzelle auf der oberen Teilzelle mittels eines Epitaxie Prozesses hergestellt wird, wobei die untere Teilzelle eine InGaNAs-Schicht umfasst und eine kleinere Bandlücke als die obere Teilzelle aufweist und die Dicke der InGaNAs-Schicht größer als 100 nm ist und die InGaNAs-Schicht als Teil des Emitters und / oder als Teil der Basis und / oder als Teil der zwischen Emitter und Basis liegenden Raumladungszone ausgebildet ist, und die untere Teilzelle eine Fläche größer als 1 mm² aufweist, und in einem dritten Schritt auf der unteren Teilzelle eine planare und im Wesentlichen vollflächige oder vollflächige Anschlusskontaktschicht aus Metall ausgebildet wird, wobei die Anschlusskontaktschicht eine stoffschlüssige Verbindung zu einer III-V Halbleiterschicht der darunterliegenden unteren Teilzelle ausbildet und die Anschlusskontaktschicht weniger als 20 µm von der unteren Teilzelle entfernt angeordnet wird oder in dem dritten Schritt auf der unteren Teilzellen eine als weitere Teilzelle ausgebildete Halbleiterträgerschicht mittels eines Halbleiterbondierungsverfahrens angeordnet wird, wobei während des Halbleiterbondierungsverfahrens zwischen der unteren Teilzelle und der Halbleiterträgerschicht eine amorphe Halbleiterverbindungsschicht mit einer Dicke dₐ mit 1 nm ≤ dₐ ≤ 50 nm, vorzugsweise mit 1 nm ≤ dₐ ≤ 20 nm, ausgebildet wird, und die Halbleiterverbindungsschicht für Wellenlängen oberhalb 1240 nm transparent ist und die Halbleiterverbindungsschicht in dem Wellenlängenbereich oberhalb 1240 nm weniger als 25% der Photonen absorbiert und in einem vierten Prozessschritt die Halbleitersubstratscheibe entfernt wird. Hierdurch wird letztlich der Stapel aus einzelnen Teilzellen invertiert, d. h. die oberste Teilzelle weist die größte Bandlücke auf. Die Einstrahlung von Licht erfolgt immer durch die obere Teilzelle.

Es sei angemerkt, dass bei der unteren Teilzelle die InGaNAs -Schicht als Teil des Emitters und / oder als Teil der Basis und / oder als Teil der zwischen Emitter und Basis liegenden Raumladungszone ausbilden lässt. Auch ist es vorteilhaft der InGaNAs -Schicht Antimon beizufügen. Hierdurch lassen sich insbesondere ein GaAs-Emitter und eine InGaNAs-Basis als sogenannte Hetereojunktion-Tellzelle ausbilden. Des Weiteren lässt sich auch die InGaNAs - Schicht in einer sogenannten PIN-Struktur zwischen dem GaAs-Emitter und der GaAs-Basis ausbilden. Des Weiteren sei angemerkt, dass vorliegend unter der Bezeichnung " integriert" eine stapelförmige Mehrfachsolarzelle hergestellt mittels von Epitaxieverfahren und /oder Halbleiterbondierungsverfahren verstanden wird. Derartige Mehrfachsolarzellen lassen sich auch als monolithisch integriert bezeichnen.

Ein Vorteil der erfindungsgemäßen Anordnung und des Verfahrens ist es, dass sich eine Teilzelle aus InGaNAs mit hoher Materialqualität sich einfach und zuverlässig herstellen lässt und sich eine stapelförmige Anordnung der Teilzellen auf einfache Weise ausbilden und vollflächig mit einem Trägermaterial beispielsweise aus Metall oder einer metallisch leitfähigen Verbindung oder einer weiteren aktiven Solarzelle aus Halbleitermaterial/Germanium erzeugen lässt. Untersuchungen haben gezeigt, dass sich mit der erfindungsgemäßen Anordnung und Verfahren besonders hohe Wirkungsgrade erreichen lassen die vorzugsweise oberhalb 44% liegen. Ferner ist die stapelförmige Anordnung sehr gewichtssparend und weist eine sehr gute thermische Leitfähigkeit auf. Des Weiteren lassen sich ohne weiteres Zellengrößen oberhalb 1 mm² Fläche herstellen.

Weitere Untersuchungen haben gezeigt, dass mittels des vorliegenden Verfahrens die Herstellung überwiegend mit einem kostengünstigen Gasphasen-Epitaxie-Verfahren, auch als MOVPE-Verfahren bezeichnet, durchführen lassen. In einer bevorzugten Ausführungsform ist es hinreichend, nur die InGaNAs Schicht mittels eines Molekularstrahlepitaxieverfahrens herzustellen. Vorteilhaft ist ebenfalls, dass die untere Teilzelle oder die Mehrfachsolarzelle insgesamt eine Fläche größer als 3mm² oder vorzugsweise größer als 5 mm² aufweisen.

In einer Weiterbildung weist die Anschlusskontaktschicht eine Dicke dₘ mit 10 nm ≤ dₘ ≤ 100 µm auf. Vorteilhaft ist die Anschlusskontaktschicht aus einem Metall oder aus einer Mehrzahl von Metallen auszubilden. In einer Ausführungsform umfasst die Anschlusskontaktschicht mehrere unterschiedliche Metallschichten, wobei die Anschlusskontaktschicht Indium umfasst und vorzugsweise eine Schicht mit einem Indium-Anteil größer als 5% bezogen auf das Gewicht der Schicht aufweist.

In einer bevorzugten Ausführungsform ist zwischen der mittleren Teilzelle und der unteren Teilzelle ein Halbleiterspiegel ausgebildet. Auch ist es vorteilhaft unter der unteren Teilzelle einen Halbleiterspiegel auszubilden, um Licht in die untere Teilzelle zu reflektieren. Hierdurch lässt sich die Dicke der jeweiligen Teilzellen reduzieren. Auch ist es vorteilhaft, die Dicke der InGaNAs-Schicht kleiner als 2 µm auszubilden.

In einer anderen Weiterbildung ist eine mittlere Teilzelle zwischen der oberen Teilzelle und der unteren Teilzelle vorgesehen, wobei die mittlere Teilzelle eine kleinere Bandlücke als die obere Teilzelle und eine größere Bandlücke als die untere Teilzelle aufweist.

In einer Ausführungsform ist unterhalb der unteren Teilzelle eine weitere Teilzelle angeordnet und die weitere Teilzelle eine kleinere Bandlücke als die untere Teilzelle aufweist. Bevorzugt ist, dass die weitere Teilzelle als eine Ge-Teilzelle ausgebildet ist.

In einer anderen Ausführungsform weist die unterhalb der InGaNAs-Schicht ausgebildete III-V Halbleiterschicht oder die Halbleiterschichten eine Gesamtdicke kleiner als 10 µm auf, anders ausgedrückt, die Anschlusskontaktschicht ist weniger als 10 µm von der unteren Teilzelle entfernt. In einer bevorzugten Weiterbildung sind die obere Tellzelle und die mittlere Teilzelle und die untere Teilzelle jeweils zueinander gitterangepasst ausgebildet. Es sei angemerkt, dass vorliegend unter dem Begriff gitterangepasst einen Unterschied in der Gitterkonstante zwischen zwei Teilzellen von kleiner als 0,01 Å Schicht verstanden wird.

In einer Weiterbildung ist zwischen den Teilzellen jeweils eine Tunneldiode aus einem III-V Material angeordnet. Es sei angemerkt, dass die Tunneldiode sich zwischen der unteren Teilzelle und der Halbleiterverbindungsschicht las auch zwischen der Halbleiterverbindungsschicht und der weiteren Teilzelle die ausbilden lässt.

Bevorzugt ist, dass die obere Teilzelle als eine (Al)InGaP-Teilzelle und/ oder die mittlere Teilzelle als eine (Al)(In)GaAs(P)-Teilzelle auszubilden.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Fig. 1a - 1d: eine Ansicht auf Verfahrensschritte zur Herstellung einer erfindungsgemäßen Ausführungsform,
- Fig. 2: eine Querschnittsansicht auf den Schichtaufbau einer Dreifach-Solarzelle,
- Fig. 3: eine Querschnittsansicht auf den Schichtaufbau einer Vierfach-Solarzelle.

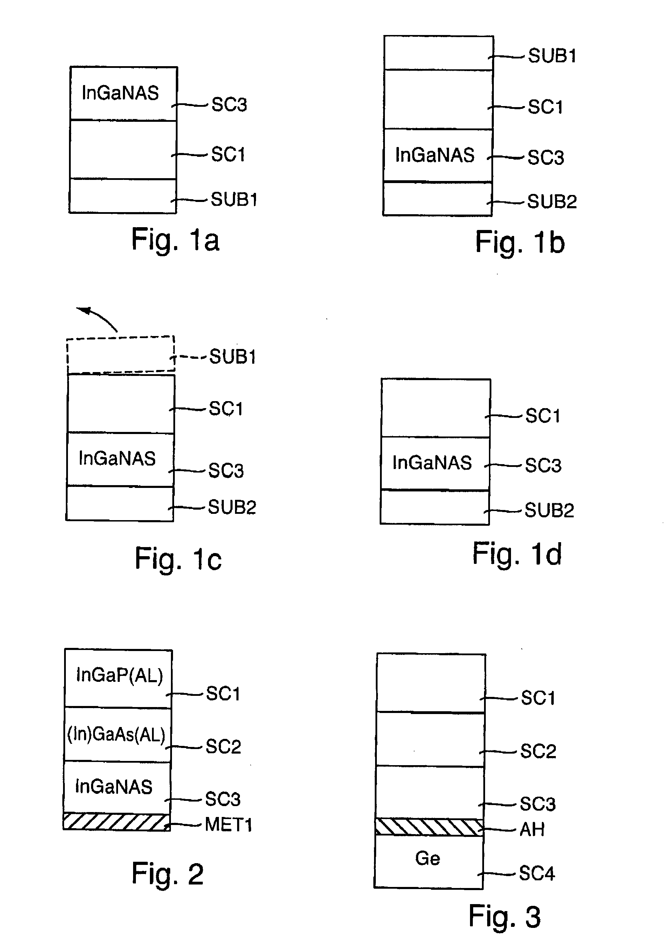

Die Abbildung der Figuren 1a bis 1d zeigt eine Ansicht auf Verfahrensschritte zur Herstellung einer erfindungsgemäßen stapelförmigen integrierten Mehrfachsolarzelle. In der Abbildung der Fig. 1a wird in einem ersten Schritt mittels einer Gasphasenepitaxie eine obere Teilzelle SC1 auf einer Halbleitersubstratscheibe SUB1 hergestellt. In einem zweiten Schritt wird eine untere Teilzelle SC3 auf der oberen Teilzelle SC1 mittels eines weiteren Epitaxie Prozesses, vorzugsweise mittels eines Molekularstrahlverfahren, abgekürzt als MBE bezeichnet, hergestellt. Hierbei umfasst die untere Teilzelle SC3 eine InGaNAs-Schicht mit einer kleineren Bandlücke als die obere Teilzelle SC1, wobei die Dicke der InGaNAs-Schicht größer als 100 nm ist und als Teil des Emitters und / oder als Teil der Basis und / oder als Teil der zwischen Emitter und Basis liegenden Raumladungszone ausgebildet ist.

In der Abbildung der Fig. 1b ist in einem dritten Schritt auf der unteren Teilzelle SC3 eine Trägerschicht SUB2 ausgebildet. Die Trägerschicht SUB2 lässt sich als planare und im Wesentlichen vollflächige oder vollflächige Anschlusskontaktschicht aus Metall oder einer metallischen Verbindung ausbilden. Hierdurch wird der Solarzellenstapel besonders vorteilhaft elektrisch kontaktiert. Im Unterschied zu der Abbildung der Figur 1a ist der Solarzellenstapel invertiert, d.h. die Teilzelle mit der größten Bandlücke ist nunmehr oben unmittelbar unterhalb der Halbleitersubstratscheibe SUB1 angeordnet.

In einem vierten Prozessschritt, dargestellt in der Abbildung der Figur 1c wird die Halbleitersubstratscheibe SUB1 entfernt und in der Abbildung der Figur 1d ist der Aufbau einer Zweifach-Solarzelle dargestellt.

In der Abbildung der Figur 2 ist eine Querschnittsansicht auf den Schichtaufbau einer Dreifach-Solarzelle dargestellt. Im Folgenden werden nur die Unterschiede zu der Abbildung der Figur 1 erläutert. Nach dem ersten Schritt und vor dem zweiten Schritt wird mittels eines weiteren Gasphasenepitaxieschrittes eine mittlere Teilzelle SC2 auf der oberen Teilzelle SC1 hergestellt. Es versteht sich, dass mittlere Teilzelle SC2 eine kleinere Bandlücke als die obere Teilzelle SC1 und eine größere Bandlücke als die untere Teilzelle SC3 aufweist.

Vorteilhaft ist die obere Teilzelle SC1 aus einer (Al)InGaP Verbindung und die mittlere Teilzelle aus einer (Al)(In)GaAs(P) Verbindung und die untere Teilzelle aus der InGaNAs Verbindung herzustellen. Des Weiteren ist es bevorzugt, die Anschlusskontaktschicht aus einem Metall MET1 mit einer Dicke dₘ mit 10 nm ≤ dₘ ≤ 100 µm ausgebildet ist.

In der Figur 3 ist eine Querschnittsansicht auf den Schichtaufbau einer Vierfach-Solarzelle dargestellt. Im Folgenden werden nur die Unterschiede zu der Abbildung der Figur 1 und der Figur 2 erläutert. In dem dritten Schritt wird als Trägerschicht SUB2 die Anschlusskontaktschicht als eine amorphe Halbleiterverbindungsschicht AH zur Ausbildung einer stoffschlüssigen Verbindung zu einer unterhalb der unteren Teilzelle SC3 angeordneten weiteren Teilzelle SC4 ausgebildet. Hierbei wird die weitere Teilzelle SC4 mittels eines Halbleiterbondierungsverfahrens angeordnet. Bei dem Halbleiterbondierungsverfahrens wird die amorphe Halbleiterverbindungsschicht AH mit einer Dicke dₐ mit 1 nm ≤ dₐ ≤ 50 nm ausgebildet, wobei die Halbleiterverbindungsschicht für Wellenlängen oberhalb 1240 nm transparent ist und die Halbleiterverbindungsschicht in dem Wellenlängenbereich oberhalb 1240 nm weniger als 25% der Photonen absorbiert.

Die weitere Tellzelle SC4 ist vorzugsweise aus Germanium aufgebaut und weist eine kleinere Bandlücke als die untere Teilzelle SC3 auf.

## Patentansprüche

1. Stapelförmige integrierte Mehrfachsolarzelle, mit
einer oberen Teilzelle (SC1) und einer unteren Teilzelle (SC3), wobei die obere Teilzelle (SC1) eine größere Bandlücke als die untere Teilzelle (SC3) aufweist, und jede der Teilzellen (SC1, SC3) einen Emitter und eine Basis aufweist, und
die untere Teilzelle (SC3) eine InGaNAs-Schicht aufweist und die Dicke der InGaNAs-Schicht größer als 100 nm ist und die InGaNAs -Schicht als Teil des Emitters und / oder als Teil der Basis und / oder als Teil der zwischen Emitter und Basis liegenden Raumladungszone ausgebildet ist,
**dadurch gekennzeichnet, dass**
die untere Teilzelle (SC3) eine Fläche größer als 1 mm² aufweist, und
- in einer ersten Alternative unterhalb der InGaNAs-Schicht eine planare und im Wesentlichen vollflächige oder vollflächige Anschlusskontaktschicht aus Metall (MET1) ausgebildet ist und die Anschlusskontaktschicht eine stoffschlüssige Verbindung zu einer III-V Halbleiterschicht der darüber liegenden unteren Teilzelle (SC3) aufweist und die Anschlusskontaktschicht weniger als 20 µm von der unteren Teilzelle (SC3) entfernt ist, oder
- in einer zweiten Alternative unterhalb der InGaNAs-Schicht eine amorphe Halbleiterverbindungsschicht (AH) ausgebildet ist, wobei die Halbleiterverbindungsschicht (AH) eine Dicke dₐ mit 1 nm ≤ dₐ ≤ 50 nm umfasst und die Halbleiterverbindungsschicht (AH) für Wellenlängen oberhalb 1240 n nm transparent ist und die Halbleiterverbindungsschicht (AH) in dem Wellenlängenbereich oberhalb 1240 nm weniger als 25% der Photonen absorbiert.

2. Stapelförmige integrierte Mehrfachsolarzelle nach Anspruch 1, **dadurch gekennzeichnet, dass** eine mittlere Teilzelle (SC2) zwischen der oberen Teilzelle (SC1) und der unteren Teilzelle (SC3) vorgesehen ist und die mittlere Teilzelle (SC2) eine kleinere Bandlücke als die obere Teilzelle (SC1) und eine größere Bandlücke als die untere Teilzelle (SC3) aufweist.

3. Stapelförmige integrierte Mehrfachsolarzelle nach Anspruch 1 oder Anspruch 2, **dadurch gekennzeichnet, dass** das Metall (MET1) eine Dicke dₘ mit 10 nm ≤ dₘ ≤ 100 µm aufweist.

4. Stapelförmige integrierte Mehrfachsolarzelle nach einem der vorangegangenen Ansprüche, **dadurch gekennzeichnet, dass** die Anschlusskon-taktschicht Indium, insbesondere eine Schicht mit einem Indium-Anteil größer als 5% bezogen auf das Gewicht der Schicht enthält.

5. Stapelförmige integrierte Mehrfachsolarzelle nach einem der vorangegangenen Ansprüche, **dadurch gekennzeichnet, dass** unterhalb der unteren Teilzelle (SC3) eine weitere Teilzelle (SC4) angeordnet ist und die weitere Teilzelle (SC4) eine kleinere Bandlücke als die untere Teilzelle (SC3) aufweist und die weitere Teilzelle (SC4) als eine Ge-Teilzelle ausgebildet ist.

6. Stapelförmige integrierte Mehrfachsolarzelle nach einem der vorangegangenen Ansprüche, **dadurch gekennzeichnet, dass** die untere Teilzelle (SC3) eine Fläche größer als 3mm² oder größer als 5 mm² aufweist.

7. Stapelförmige integrierte Mehrfachsolarzelle nach einem der vorangegangenen Ansprüche, **dadurch gekennzeichnet, dass** die obere Teilzelle (SC1) und die mittlere Tellzelle (SC2) und die untere Teilzelle (SC3) jeweils zueinander gitterangepasst ausgebildet sind, wobei der Unterschied in der Gitterkonstante kleiner als 0,01 Å ist.

8. Stapelförmige integrierte Mehrfachsolarzelle nach einem der vorangegangenen Ansprüche, **dadurch gekennzeichnet, dass** zwischen den Teilzellen (SC1, SC2, SC3, SC4) jeweils eine Tunneldiode aus einem III-V Material angeordnet ist.

9. Stapelförmige integrierte Mehrfachsolarzelle nach einem der vorangegangenen Ansprüche, **dadurch gekennzeichnet, dass** die obere Tellzelle (SC1) als eine (Al)InGaP-Teilzelle und/ oder die mittlere Teilzelle (SC2) als eine (Al)(In)GaAs(P)-Teilzelle ausbildet ist.

10. Stapelförmige integrierte Mehrfachsolarzelle nach einem der Ansprüche 2 bis 9, **dadurch gekennzeichnet, dass** zwischen der mittleren Tellzelle (SC2) und der unteren Teilzelle (SC3) eine Halbleiterspiegel ausgebildet ist und / oder unter der unteren Teilzelle (SC3) ein Halbleiterspiegel ausgebildet ist.

11. Verfahren zur Herstellung einer stapelförmigen integrierten Mehrfachsolarzelle, wobei
in einem ersten Schritt eine obere Teilzelle (SC1) auf einer Halbleitersubstratscheibe mittels eines Epitaxie Prozesses hergestellt wird, und
in einem zweiten Schritt eine untere Teilzelle (SC3) auf der oberen Teilzelle (SC1) mittels eines Epitaxie Prozesses hergestellt wird, wobei die untere Teilzelle (SC3) eine InGaNAs-Schicht umfasst und eine kleinere Bandlücke als die obere Teilzelle (SC1) aufweist und die Dicke der InGaNAs-Schicht größer als 100 nm ist und die InGaNAs-Schicht als Teil des Emitters und / oder als Teil der Basis und / oder als Teil der zwischen Emitter und Basis liegenden Raumladungszone ausgebildet ist, und die untere Teilzelle (SC3) eine Fläche größer als 1 mm² aufweist, und
in einem dritten Schritt auf der unteren Teilzelle (SC3) eine planare im Wesentlichen vollflächige oder vollflächige Anschlusskontaktschicht aus Metall ausgebildet wird, wobei die Anschlusskontaktschicht eine stoffschlüssige Verbindung zu einer III-V Halbleiterschicht der darunterliegenden unteren Teilzelle (SC3) ausbildet und die Anschlusskontaktschicht weniger als 20 µm von der unteren Teilzelle (SC3) entfernt angeordnet wird oder in dem dritten Schritt auf der unteren Teilzelle (SC3) eine als weitere Teilzelle (SC4) ausgebildete Halbleiterträgerschicht mittels eines Halbleiterbondierungsverfahrens angeordnet wird, wobei während des Halbleiterbondierungsverfahrens zwischen der unteren Teilzelle (SC3) und der Halbleiterträgerschicht eine amorphe Halbleiterverbindungsschicht (AH) mit einer Dicke dₐ mit 1 nm ≤ dₐ ≤ 50 nm ausgebildet wird, und die Halbleiterverbindungsschicht (AH) für Wellenlängen oberhalb 1240 nm transparent ist und die Halbleiterverbindungsschicht (AH) in dem Wellenlängenbereich oberhalb 1240 nm weniger als 25% der Photonen absorbiert und in einem vierten Prozessschritt die Halbleitersubstratscheibe (SUB1) entfernt wird.

12. Verfahren zur Herstellung einer stapelförmigen integrierten Mehrfachsolarzelle nach Anspruch 11, **dadurch gekennzeichnet, dass** die Anschlusskontaktschicht aus Metall (MET1) mit einer Dicke dₘ 10 nm ≤ dₘ ≤ 100 µm ausgebildet wird.

13. Verfahren zur Herstellung einer stapelförmigen integrierten Mehrfachsolarzelle nach Anspruch 11 oder Anspruch 12, **dadurch gekennzeichnet, dass** die Anschlusskontaktschicht mit Indium ausgebildet wird und insbesondere in der Anschlusskontaktschicht eine Indium-Schicht mit einem Indium Anteil größer als 5% bezogen auf das Gewicht der Schicht ausgebildet wird.

14. Verfahren zur Herstellung einer stapelförmigen integrierten Mehrfachsolarzelle nach Anspruch 11 bis 13, **dadurch gekennzeichnet, dass** eine mittlere Teilzelle (SC2) zwischen der oberen Teilzelle (SC1) und der unteren Teilzelle (SC3) ausgebildet wird und die mittlere Teilzelle (SC2) eine kleinere Bandlücke als die obere Teilzelle (SC1) und eine größere Bandlücke als die untere Teilzelle (SC3) aufweist.

15. Verfahren zur Herstellung einer stapelförmigen integrierten Mehrfachsolarzelle nach einem der Ansprüche 11 bis 13, **dadurch gekennzeichnet, dass** eine weitere Teilzelle (SC4) ausgebildet wird und die weitere Teilzelle (SC4) als eine Ge-Teilzelle hergestellt wird.

16. Verfahren zur Herstellung einer stapelförmigen integrierten Mehrfachsolarzelle nach einem der Ansprüche 11 bis 15, **dadurch gekennzeichnet, dass** die unterhalb der InGaNAs-Schicht ausgebildete III-V Halbleiterschicht oder Halbleiterschichten mit einer Dicke kleiner als 10 µm ausgebildet wird.

17. Verfahren zur Herstellung einer stapelförmigen integrierten Mehrfachsolarzelle nach einem der Ansprüche 11 bis 16, dass die obere Teilzelle (SC1) und die mittlere Teilzelle (SC2) und die untere Teilzelle (SC3) jeweils zueinander gitterangepasst mit einem Unterschied in der Gitterkonstante jeweils kleiner als 0,01 Å ausgebildet werden.

18. Verfahren zur Herstellung einer stapelförmigen integrierten Mehrfachsolarzelle nach einem der Ansprüche 11 bis 17, **dadurch gekennzeichnet, dass** als obere Teilzelle (SC1) eine InGaP-Teilzelle und / oder als mittlere Teilzelle (SC2) eine (Al)(In)GaAs(P)-Teilzelle ausbildet werden.

19. Verfahren zur Herstellung einer stapeiförmigen integrierten Mehrfachsolarzelle nach einem der Ansprüche 11 bis 18, **dadurch gekennzeichnet, dass** in dem ersten Schritt ein anderer epitaktischer Prozess als in dem zweiten Schritt durchgeführt wird und in dem zweiten Schritt ein MBE-Prozess zur Herstellung der unteren Teilzelle (SC3) durchgeführt wird.

20. Verfahren zur Herstellung einer stapelförmigen integrierten Mehrfachsolarzelle nach einem der Ansprüche 11 bis 18, **dadurch gekennzeichnet, dass** zwischen der mittleren Teilzelle (SC2) und der unteren Teilzelle (SC3) eine Halbleiterspiegel angeordnet wird und / oder unter der unteren Teilzelle (SC3) ein Halbleiterspiegel angeordnet wird und / oder die Dicke der InGaNAs Schicht kleiner als 2µm ausgebildet wird.
